| (19) | Europäisches Patentamt<br>European Patent Office<br>Office européen des brevets | (11) Veröffentlichungsnummer: **0 320 596 B1** |

## (12) EUROPÄISCHE PATENTSCHRIFT

(45) Veröffentlichungstag der Patentschrift: **27.05.92**

(21) Anmeldenummer: **88117227.4**

(22) Anmeldetag: **17.10.88**

(51) Int. Cl.⁵: **G01D 5/26**

---

(54) **Positionsmesseinrichtung mit Unterteilungsschaltung.**

---

(30) Priorität: **14.12.87 DE 3742329**

(43) Veröffentlichungstag der Anmeldung:
**21.06.89 Patentblatt 89/25**

(45) Bekanntmachung des Hinweises auf die
Patenterteilung:
**27.05.92 Patentblatt 92/22**

(84) Benannte Vertragsstaaten:
**DE FR GB IT**

(56) Entgegenhaltungen:
**CH-A- 407 569**

(73) Patentinhaber: **Dr. Johannes Heidenhain
GmbH
Dr.-Johannes-Heidenhain-Strasse 5 Postfach
1260
W-8225 Traunreut(DE)**

(72) Erfinder: **Schwefel, Ernst, Dipl.-Phys.
Reichenbergweg 2
W-8225 Traunreut(DE)**
Erfinder: **Schmitt, Walter, Ing.(Grad.)
Hochgernstrasse 22
W-8225 Traunreut(DE)**
Erfinder: **1Huber, Norbert, Dipl.-Ing. (FH)
Sudetenstrasse 24
W-8225 Traunreut(DE)**
Erfinder: **Lengenfelder, Hans, Dipl.-Ing. (FH)
Ahamer Strasse 69
W-8260 Mühldorf(DE)**

**Beschreibung**

Die Erfindung bezieht sich auf eine Positionsmeßeinrichtung gemäß dem Oberbegriff des Anspruches 1. Inkrementale Meßsysteme, von denen die Erfindung ausgeht, liefern bekanntlich Impulse, deren Anzahl ein Maß für die lineare Verschiebung oder den Drehwinkel darstellt. Diese Impulse werden in einem elektronischen Vor-/Rückwärtszähler als Wegelemente aufsummiert und der Meßwert numerisch angezeigt.

Die Auflösung von inkrementalen Positionsmeßeinrichtungen ist ohne weitere elektronische Unterteilung zunächst nur 1/4 der Teilungsperiode, da von zwei um 90° zueinander versetzten Fotodetektoren der Abtasteinheit zwei entsprechend zueinander phasenverschobene Signale U1 und U2 erzeugt werden, die vier Nulldurchgänge zum Erzeugen von Zählimpulsen aufweisen. Besitzen die beiden Signale eine genügend gute Sinusform, lassen sie sich zwischen den Nulldurchgängen auf verschiedene Weise elektrisch interpolieren.

Für das nachstehende Beispiel sei die CH-C-407 569 genannt.

Eine Möglichkeit zur elektronischen Meßwertinterpolation ist die Erzeugung von zusätzlichen Hilfsphasen in einem Widerstandsnetzwerk. Die mathematische Grundlage dafür bietet das Additionstheorem. Wählt man die Amplituden der beiden Siganle

$$U1 = A1 \sin (2\pi X/P)$$
und
$$U2 = A2 \cos (2\pi X/P)$$

wobei P = Signalperiode
so, daß

$$A1 = \cos \zeta$$
und
$$A2 = \sin \zeta ,$$

ergibt sich durch Addition der beiden Signale ein neues Signal

$$U = \sin (\zeta + 2\pi X/P)$$

das zu U1 um $\zeta$ phasenverschoben ist. X ist der Weg oder der Winkel und $\zeta$ eine Hilfsgröße, die entsprechend dem geforderten Interpolationsgrad gewählt wird.

In modernen Auswerteelektroniken werden auf diese Weise bis zu 25fach-phasenverschobene Signale erzeugt und somit Auflösungen des Meßsystems bis zu 1/100 der Maßstabteilungsperiode erreicht.

Für derartig hohe Unterteilungen ist allerdings der Schaltungsaufwand bereits recht hoch, da für jedes phasenverschobene Signal ein Schaltbaustein vorgesehen werden muß. So muß bisher die Anzahl der Trigger immer das Doppelte des Unterteilungsfaktors betragen.

Der Erfindung liegt daher die Aufgabe zugrunde, eine Positionsmeßeinrichtung der eingangs genannten Art so zu verbessern, daß der Schaltungsaufwand nicht proportional zum Unterteilungsfaktor ansteigt.

Diese Aufgabe wird bei einer Positionsmeßeinrichtung mit den Merkmalen des Anspruches 1 gelöst. Vorteilhafte Ausgestaltungen entnimmt man den abhängigen Ansprüchen.

Die besonderen Vorteile liegen darin, daß die Schaltbausteine mehrfach genutzt werden können, so daß eine erheblich geringere Anzahl von Triggern ausreicht.

Mit Hilfe von Ausführungsbeispielen soll die Erfindung anhand der Zeichnungen nachstehend noch näher erläutert werden.

Es zeigt

Figur 1     ein Prinzipschaltbild;
Figur 2     ein Blockschaltbild mit zwei Triggern;
Figur 3     ein Blockschaltbild mit zwei Triggergruppen;
Figur 4     ein Blockschaltbild mit drei Triggergruppen;
Figur 5     ein Blockschaltbild mit drei Triggergruppen und Steuerlogik;
Figur 6     ein Signaldiagramm;
Figur 7     ein weiteres Signaldiagramm;
Figur 8     ein Blockschaltbild mit zwei Abtaststellen.

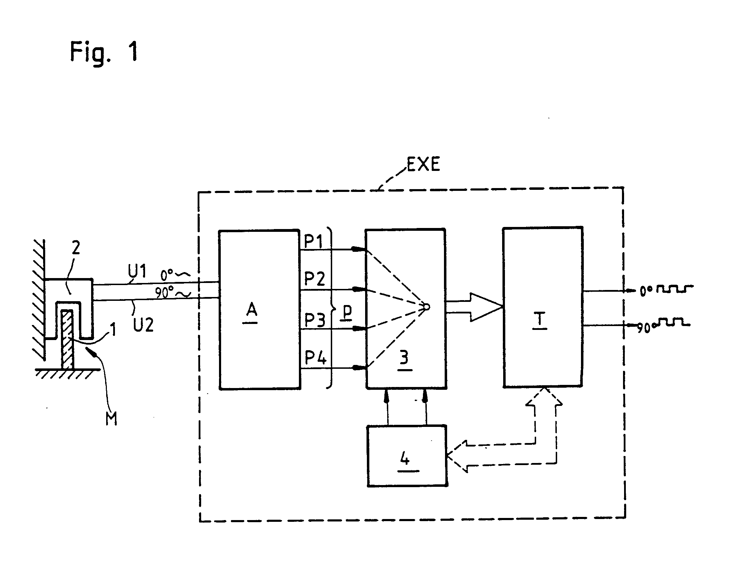

Das Prinzipschaltbild aus Figur 1 zeigt eine Positionsmeßeinrichtung M, die eine Maßverkörperung 1 und eine Abtasteinrichtung 2 aufweist. Die Maßverkörperung 1 und die Abtasteinrichtung 2 sind jeweils an einem von zwei nicht näher bezeichneten Maschinen-Bauteilen befestigt, deren Relativbewegung gemessen werden soll. Bei Relativbewegungen der Maschinen-Bauteile werden von der Abtasteinrichtung 2 durch Abtastung der Maßverkörperung 1 in bekannter Weise analoge Abtastsignale U1, U2 erzeugt, die etwa sinusförmig sind. Zur Erkennung der Bewegungsrichtung sind die Abtastsignale U1, U2 zueinander um 90° phasenverschoben. Im Sprachgebrauch haben sich deshalb auch Begriffe wie Sinussignal und Cosinussignal oder auch 0°- und 90°-Signal durchgesetzt.

Die Abtastsignale U1, U2 werden in eine Analogsignal-Aufbereitungsschaltung A eingespeist. Dort wird eine Signalperiode P der Abtastsignale U1, U2 in eine Anzahl von Sektoren P1, P2, P3, P4 zerlegt. Die Anzahl der Sektoren Pn richtet sich nach dem gewünschten Unterteilungsgrad und den Schaltungsbestandteilen, die der Analogsignal-Aufbereitungsschaltung A nachgeordnet sind. Die Sektoren P1, P2, P3, P4 werden durch ihre zugehörigen Randsignale begrenzt.

Im Falle des Beispieles aus Figur 1 umfaßt jeder Sektor einen Bereich von $\pi/2$, so daß hier von Quadranten gesprochen werden kann, die damit eine Sonderform der Sektorenaufteilung darstellen.

Ein Schaltbaustein 3, der von einer Steuerschaltung 4 angesteuert wird, ist sowohl mit der Analogsignal-Aufbereitungsschaltung A als auch mit einem Komparator T verbunden. Im Komparator T befindet sich wenigstens ein Triggerbaustein. Da jedoch die Analogsignale U1, U2 möglichst hoch zu unterteilen sind, werden in der Praxis mehrere Triggerbausteine als Triggergruppen im Komparator T realisiert sein. Anhand der folgenden Figuren werden diese Fälle noch erörtert.

In Abhängigkeit von Steuersignalen, die ihm von der Steuerschaltung 4 zugeführt werden, schaltet der Schaltbaustein 3 den Komparator T in einer vorbestimmbaren Folge auf die einzelnen Sektoren P1, P2, P3, P4. Die Signale der einzelnen Sektoren P1, P2, P3, P4 werden also durch den Komparator T nacheinander getriggert, so daß am Ausgang des Komparators T Rechtecksignalfolgen der gewünschten Frequenz anstehen, die zueinander auch wieder um 90° phasenverschoben sind.

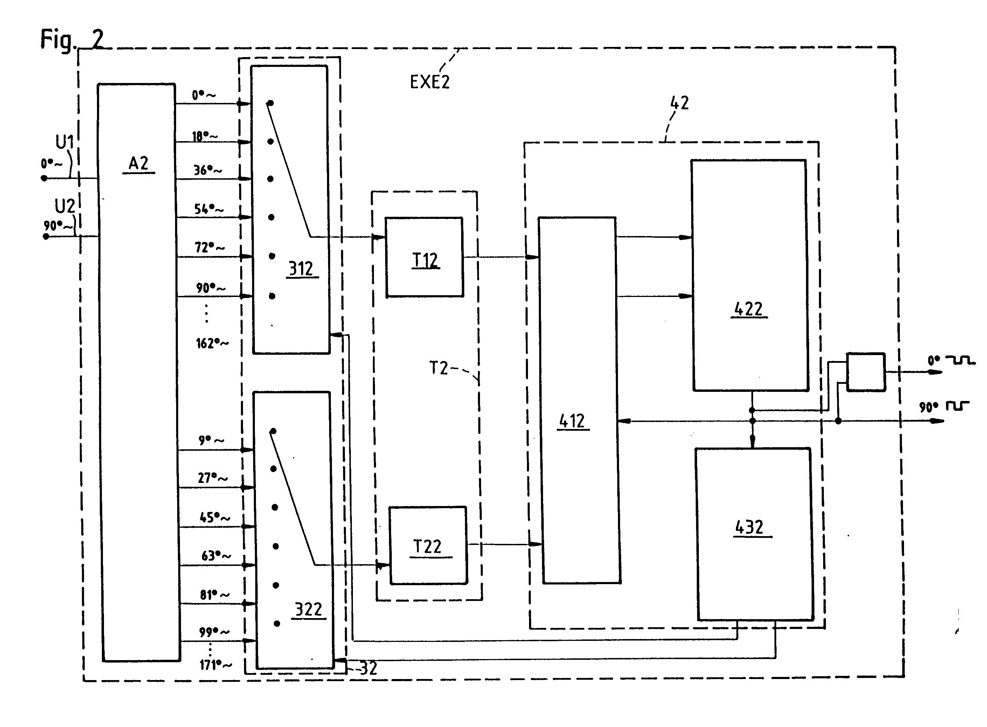

In Figur 2 ist ein Blockschaltbild dargestellt, bei dem ein Komparator T2 aus zwei Triggern T12 and T22 besteht. Ein Schaltbaustein 32 wird von zwei sogenannten Analogmultiplexern 312 und 322 gebildet. Eine Steuerschaltung 42 weist eine Auswertelogik 412, einen getakteten Vor-Rückwärtszähler 422 und einen Wandlerbaustein 432 auf, durch den aus dem Zählerstand des Vor-Rückwärtszählers 422 die Steuersignale zur Umschaltung der Analogmultiplexer 312 und 322 gewonnen werden.

Aus den analogen 0°- und 90° Abtastsignalen U1, U2 werden in der Analogsignal-Aufbereitungsschaltung A2 zwei Gruppen von jeweils zehn Signalen 0° bis 162° und 9° bis 171° gebildet, die zueinander um 18° phasenverschoben sind. Auf diese Weise sind pro analogem Abtastsignal U1 und U2 zehn Sektoren mit einer Breite von (elektrisch) 18° gebildet worden.

Die erste Gruppe von zu triggernden Analogsignalen, die aus dem Abtastsignal U1 gebildet wurden, liegt am ersten Analogmultiplexer 312 an; die aus dem Abtastsignal U2 gebildete zweite Gruppe von Analogsignalen liegt am zweiten Analogmultiplexer 322 an.

Das Beispiel zeigt, wie die Analogsignale auf die Analogmultiplexer 312 und 322 verteilt sind.

```
Das    0°-Signal liegt an der 1. Stufe des 1. Analog-
                                              multiplexers

Das   9°-Signal  "      "  "   1. "       "    2. "

Das  18°-Signal  "      "  "   2. "       "    1. "

Das  27°-Signal  "      "  "   2. "       "    2. "

Das  36°-Signal  "      "  "   3. "       "    1. "

Das  45°-Signal  "      "  "   3. "       "    2. "

u.s.w.
```

Jeder Analogmultiplexer 312 und 322 hat einen Ausgang an dem ein Trigger T12 und T22 angeschlossen ist. Die beiden Trigger T12 und T22 sind immer mit zwei benachbarten Eingangssignalen verbunden, wobei der Trigger T12 immer mit dem Eingangssignal, das die kleinere Phasenverschiebung besitzt, gekoppelt ist. Die Stellung der Analogmultiplexer 312, 322 wird dem Nulldurchgang der Eingangssignale mit Hilfe des Mitlaufenden Vor-Rückwärtszählers 422, nachgeführt. Bei stillstehender Positionsmeßeinrichtung liefern die zwei Trigger T12, T22, außerhalb der Nulldurchgänge des 0°-Signals, den Zustand 0 und 1. Ändert Trigger T12 den Zustand, bedeutet dies eine Rückwärtsbewegung. Der Vor-Rückwärtszähler 422

EP 0 320 596 B1

springt einen Schritt zurück. Ändert Trigger T22 den Zustand, muß ein Vorwärtsschritt ausgeführt werden. Die 0°- und 90°-Rechteckausgangssignale werden aus dem Zählerstand gewonnen.

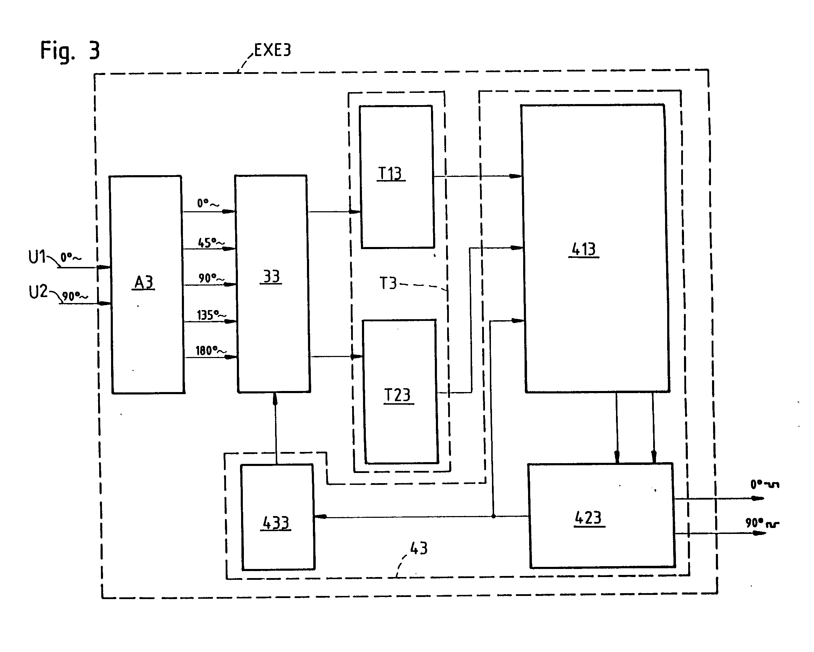

Bei dem in Figur 3 gezeigten Ausführungsbeispiel wird in der Analogsignal-Aufbereitungsschaltung A3 in der vorbeschriebenen Weise die Teilungsperiode P der Abtastsignale U1, U2 in Sektoren zerlegt. Die Randsignale eines Sektors Pi werden jeweils an eine der Triggergruppen T13 oder T23 geschaltet, die den betreffenden Sektor Pi unterteilt und die Nulldurchgänge detektiert. Das Koppeln der jeweiligen Sektorrandsignale an die betreffende Triggergruppe T13 oder T23 geschieht mittels eines Analogschaltbausteines 33. Die Schaltung EXE3 verwendet zwei Triggergruppen T13 und T23 die abwechselnd vorausschauend auf den nächsten aktuellen Sektor Pi + 1 gelegt werden. Die Zuordnung von Sektor Pi und Triggergruppe T13 oder T23 ist abhängig von der Stellung der Schalter im Analogschaltbaustein 33, der von einer Steuerschaltung 43 die Schaltbefehle bekommt. Die Steuerschaltung 43 enthält eine Auswertelogik 413, einen getakteten Vor-Rückwärtszähler 423 und einen Wandlerbaustein 433, durch den aus dem Zählerstand des Vor-Rückwärtszählers 423 die Steuersignale zur Umschaltung des Analogschaltbausteines 33 gewonnen werden.

Durchläuft die Positionsmeßeinrichtung M eine Teilungsperiode P, so muß der Vor-Rückwärtszähler 423 exakt mitgeführt werden, da er wiederum dafür sorgt, daß die richtige Triggergruppe Ti über den Analogschaltbaustein 33 mit dem richtigen Sektor Pi verbunden ist. Das Mitführen des Vor-Rückwärtszählers 423 erfolgt über die Freigabe eines Vorwärtsimpulses oder über die Freigabe eines Rückwärtsimpulses. Die Entscheidung, ob eine und welche Freigabe erfolgen soll, wird einer Tabelle entnommen, die in der Auswertelogik 413 abgelegt ist. Diese Tabelle hat als Eingangsinformation den Stand des Vor-Rückwärtszählers 423 und den Zustand der Trigger der aktuellen Triggergruppe T13 oder T23.

Bei einem bestimmten Stand des Vor-Rückwärtszählers 423 gibt es nur ein gültiges Zustandsbild der Triggergruppen T13, T23 für einen Vorwärtsimpuls und nur ein Zustandsbild für einen Rückwärtsimpuls. Beim Auftreten einer solchen Eingangskombination wird der Vor-Rückwärtszähler 423 in die eine oder andere Richtung freigegeben. Hat der Vor-Rückwärtszähler 423 diesen Zählschritt ausgeführt, ändert sich auch die Eingangsinformation der Entscheidungstabelle und die Freigabe verschwindet wieder. Die Tabelle kann als Speicherbaustein realisiert werden. Um den Vor-Rückwärtszähler 423 beim Start zu synchronisieren, wird er beim Durchlauf einer vollständigen Teilungsperiode auf Null gesetzt.

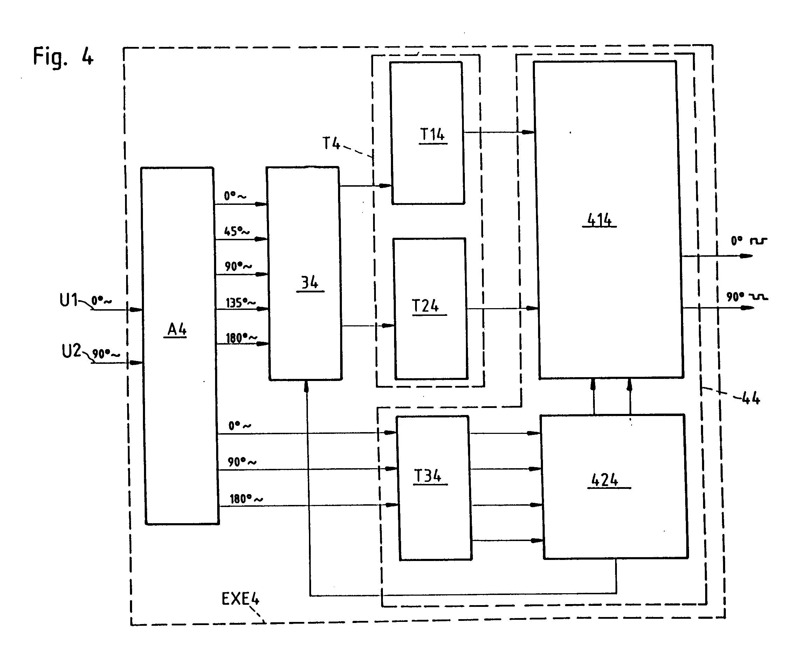

Eine weiteres Ausführungsbeispiel ist in Figur 4 gezeigt. Dort werden die Steuersignale für die Ansteuerung eines Analogschaltbausteines 34 von einer Steuerschaltung 44 geliefert, die eine Auswertelogik 414, eine weitere Triggergruppe T34 und einen Wandlerbaustein 424 aufweist.

Der Komparator T4 kann dabei eine oder mehrere Triggergruppen T14, T24 enthalten. Die nachstehenden Erläuterungen beziehen sich auf zwei Triggergruppen T14, T24.

Die phasenverschobenen Signale U1, U2 einer Teilungsperiode P werden wieder in Sektoren P1 bis Pn zerlegt. Die Randsignale eines Sektors Pi werden jeweils an eine Triggergruppe T14 oder T24 geschaltet, die den Sektor Pi unterteilt und die Nulldurchgänge detektiert. Das Verbinden der Sektorrandsignale und der Triggergruppe T14 oder T24 geschieht mit dem Analogschaltbaustein 34. Die Schaltung EXE4 verwendet zwei umschaltbare Triggergruppen T14 bis T24. Sie werden abwechselnd, vorausschauend auf den nächsten aktuellen Sektor Pi + 1 gelegt.

Die Stellung des Analogschaltbausteines 34 wird durch die Ausgangssignale der dritten Triggergruppe T34 bestimmt. Diese Triggergruppe T34 ist mit den phasenverschobenen Eingangssignalen U1, U2, -U1 verbunden und wird nicht umgeschaltet.

Die umschaltbaren Triggergruppen T14, T24 sind jeweils bestimmten Sektoren Pi zugeordnet. Hat das von der Positionsmeßeinrichtung M kommende Eingangssignal U1, U2 die Mitte des Sektors Pi durchlaufen, so wird die gerade nicht benutzte Triggergruppe T14 oder T24 umgeschaltet. Diese wird auf den Sektor Pi + 1 gelegt, der, bei Beibehaltung der Bewegungsrichtung, als nächstes durchfahren wird. Die Erkennung der Sektorenmitte erfolgt durch die starre Triggergruppe T34. Die Ausgangssignale der Triggergruppen T14, T24, T34 werden einer Auswertelogik 414 zugeführt.

Die Auswertelogik 414 enthält eine Signalsperre und einem Code-Umsetzer. Die Sperre verhindert, daß sich die Impulse, die sich aus der Triggergruppenumschaltung ergeben, auf den Ausgang auswirken. Der Code-Wandler erzeugt die 0° und 90°-Rechteck-Ausgangssignale.

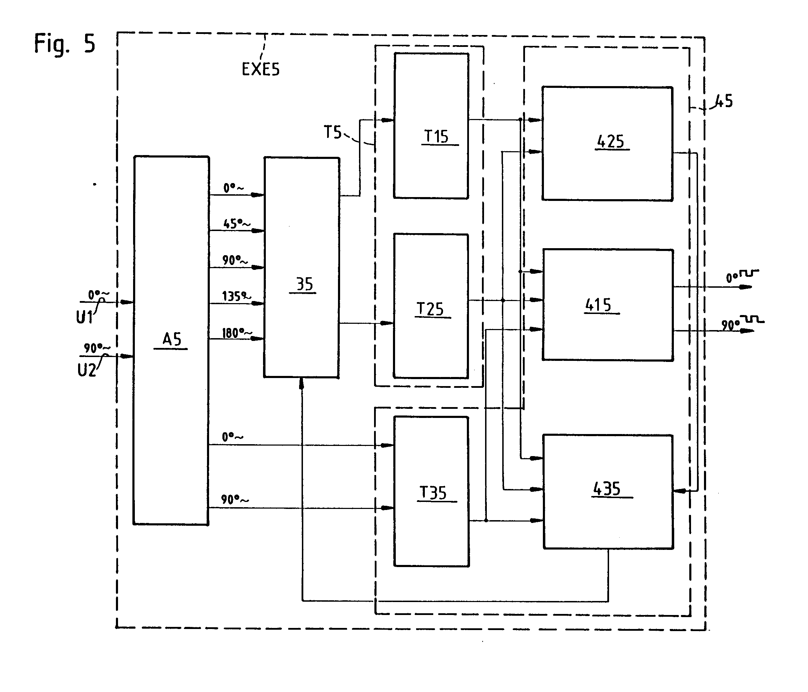

Eine ähnliche Schaltung ist als EXE5 in Figur 5 dargestellt. Aus analogen Abtastsignalen U1, U2 werden in einer Analogsignal-Aufbereitungsschaltung A5 Sektoren P1 bis Pn gebildet.

Die Randsignale eines Sektors Pi werden jeweils an eine Triggergruppe T15 oder T25 geschaltet, die den Sektor Pi unterteilt und die Nulldurchgänge detektiert.

Das Verbinden der Sektorrandsignale und der Triggergruppe T15 oder T25 geschieht mit einem Analogschaltbaustein 35. Die Schaltung EXE5 verwendet zwei umschaltbare Triggergruppen T15 und T25. Sie werden abwechselnd, vorausschauend auf den nächsten aktuellen Sektor Pi + 1 gelegt.

4

Die Stellung des Analogschaltbausteines 35 wird durch die Ausgangssignale einer weiteren, starren Triggergruppe T35 und die Ausgangssignale der umschaltbaren Triggergruppen T15 und T25 bestimmt. Die starre Triggergruppe T35 ist fest mit den phasenverschobenen Eingangssignalen U1, U2 verbunden.

Die umschaltbaren Triggergruppen T15 oder T25 sind jeweils bestimmten Sektoren Pi oder Pi + 1 zugeordnet. Hat das vom Geber kommende Eingangssignal die Mitte eines Sektors Pi durchlaufen, so wird die gerade nicht benutzte Triggergruppe T15 oder T25 umgeschaltet. Diese wird auf den Sektor Pi + 1 gelegt, der, behält man die Bewegungsrichtung bei, als nächstes durchlaufen wird. Die Erkennung der Sektorenmitte erfolgt durch die starren und die umschaltbaren Trigger T15, T25, T35.

Diese Triggerausgangssignale werden einer Steuerschaltung 45 zugeführt, die die Stellung des Analogschaltbausteines 35 bestimmt.

Die Steuerschaltung 45 enthält neben der eigentlichen Umschaltlogik 435, eine Auswertelogik 415, eine Startlogik 425 sowie die bereits erwähnte dritte Triggergruppe T35.

Die Auswertelogik 415 zur Generierung der RechteckAusgangssignale verwendet ebenfalls alle Triggersignale. Sie besteht aus einem nicht näher beschriebenen Filter für die Umschaltimpulse und einer ebenfalls nicht näher beschriebenen Code-Wandler-Stufe zur Umsetzung in die 0°- und 90°-Rechteck-Ausgangssignale. Das beschrieben Funktionsprinzip erfordert eine spezielle Startlogik 425.

Steht der Analogschaltbaustein 35 nach dem Einschalten in einer ungültigen Stellung, so muß entsprechend reagiert werden. Die ungültige Schalterstellung wird daran erkannt, daß die Ausgangszustände aller umschaltbaren Triggergruppen T15 und T25 auf EINS oder NULL stehen.

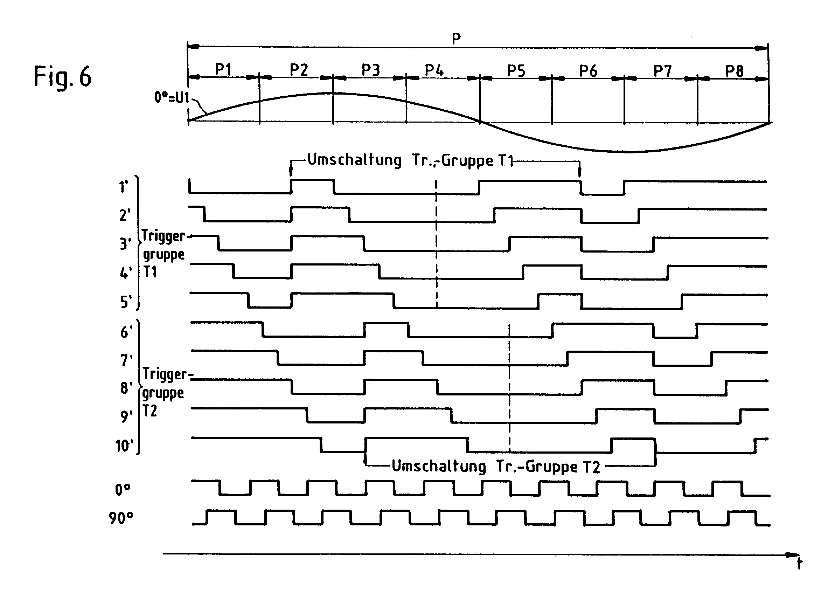

Ein Signaldiagramm, in dem eines der Abtastsignale U1 und dessen Unterteilung dargestellt ist, findet sich in der Figur 6. Dort sind zwei Triggerguppen T1 und T2 vorgesehen, die jeweils über fünf Trigger 1' bis 5' und 6' bis 10' verfügen. Eine Signalperiode P ist in diesem Fall in acht Sektoren P1 bis P8 zerlegt und jeder Sektor Pi ist durch eine der zwei Triggergruppen T1 oder T2 mit je fünf Triggern 1' bis 5' und 6' bis 10' nochmals unterteilt worden. Bei den Triggerbausteinen wurden invertierende Trigger vorausgesetzt.

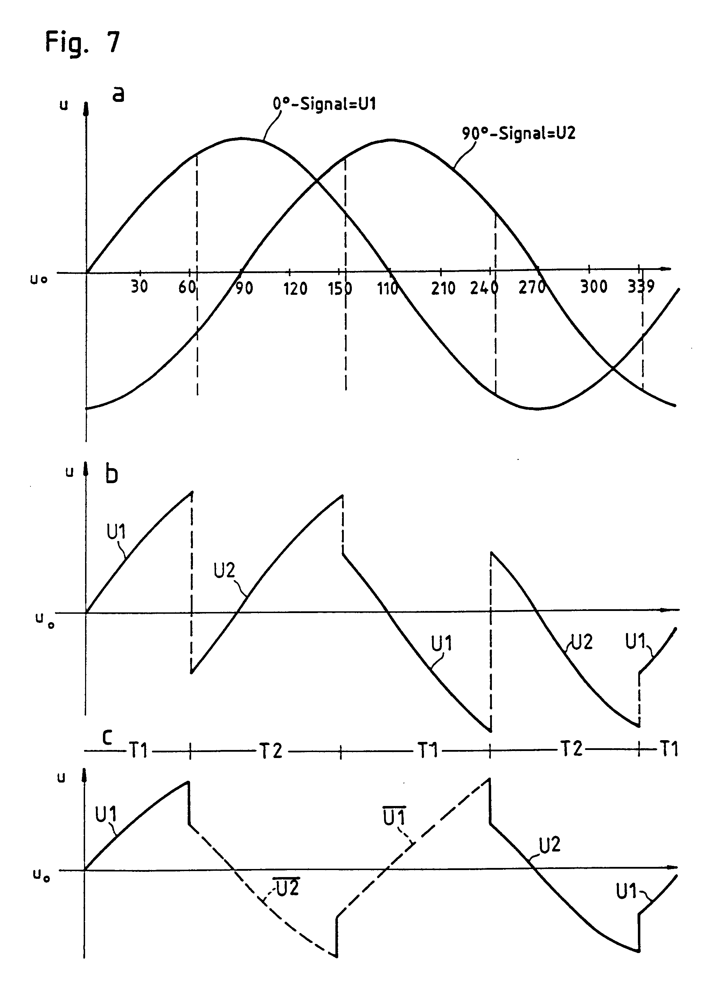

In Figur 7 ist in drei Teilskizzen a, b und c die Analogsignalumschaltung gezeigt. Figur 7a zeigt die beiden Abtastsignale U1 und U2, die um 90° zueinander phasenverschoben sind.

Durch das Umschalten der phasenverschobenen Abtastsignale U1, U2 bei einer EXE mit Analogsignalumschaltung, steigt der Oberwellenanteil der Eingangsspannung der Triggerstufen, siehe Bild 7b.

Durch das Umschalten auf die invertierten, phasenverschobenen Eingangssignale, kann der Oberwellengehalt der Eingangsspannung reduziert werden.

Bei einer EXE Mit vier Sektoren, muß zwischen 63° und 243° auf die invertierten Eingangssignale umgeschaltet werden, siehe Bild 7c.

Wird die Invertierung in analogen Teil der Schaltung ausgeführt, kann sie in der digitalen Auswertelogik eingespart werden.

Das Schaltungsprinzip - bei einer Unterteilungsschaltung EXE nur wenige Komparatoren Ti zu verwenden und diese abwechselnd auf verschiedene Sektoren der Abtastsignale U1, U2 zu schalten - kann auch sehr vorteilhaft bei Positionsmeßeinrichtungen verwendet werden, die über mehrere Abtaststellen ASI bis ASn verfügen.

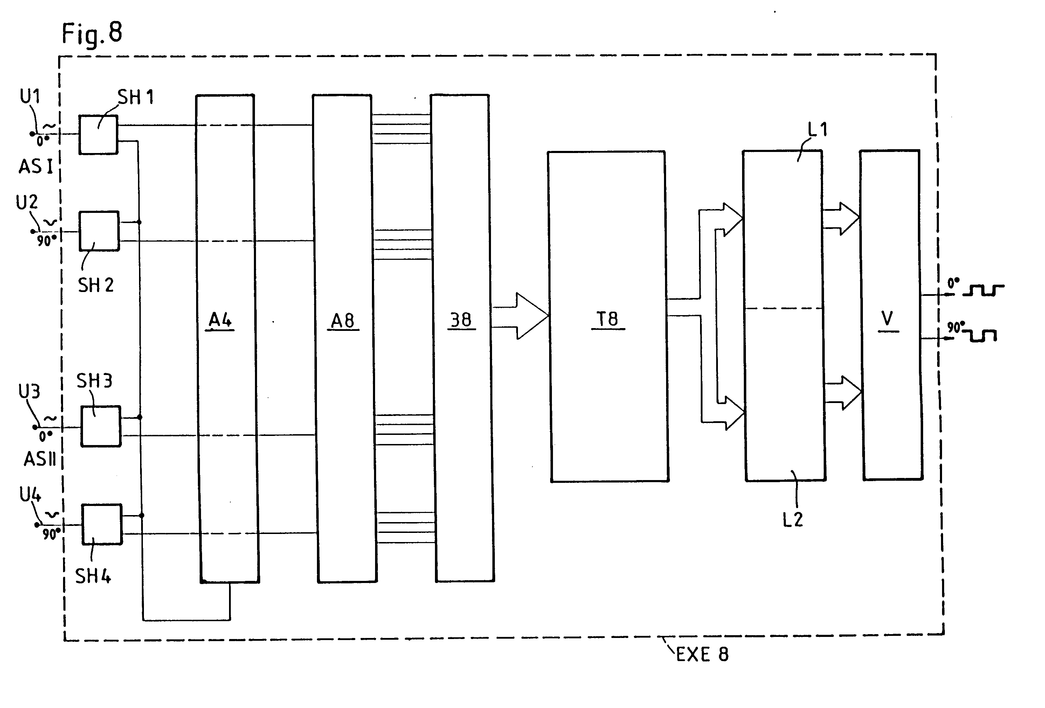

Anhand des Blockschaltbildes aus Figur 8 sei dies erläutert. Da das Unterteilungsprinzip im wesentlichen den vorangegangenen Beispielen gleicht, soll nur auf die Besonderheiten näher eingegangen werden.

Ein nicht gezeigtes Winkelmeßgerät weist zum Ausgleich der Exzentrizität zwei diametrale Abtaststellen ASI und ASII auf, jede Abtaststell ASI und ASII liefert jeweils 0°- und 90°-Signale U1, U2 und U3, U4. Damit sich der Unterteilungsaufwand durch die doppelte Anzahl von Abtaststellen ASI und ASII nicht auch verdoppelt, werden die analogen Abtastsignale U1, U2 und U3, U4 in sogenannten "sample & hold"-Speichern SH1, SH2, SH3 und SH4 zwischengespeichert. Mittels einer Speicher-Steuerschaltung A4 werden die zwischengespeicherten analogen Abtastsignale U1, U2 bzw. U3, U4 jeweils einer Abtaststelle ASI bzw. ASII nacheinander einer Analog-Aufbereitungsschaltung A8 zugeführt, wobei die Speicher SH1, SH2 bzw. SH3, SH4 nacheinander an die Analogsignal-Aufbereitungsschaltung A8 angeschaltet werden, so daß die jeweiligen Speicherinhalte abtaststellenweise übertragen werden können.

Ein Analogschaltbaustein 38 schaltet einen Komparator (T8), der aus einem oder mehreren Triggern bestehen kann, an die verschiedenen Sektoren, die, in ähnlicher Weise wie bereits beschrieben, in der Analogsingal-Aufbereitungsschaltung A8 aus den Abtastsignalen U1, U2 bzw. U3, U4 jeweils einer Abtaststelle ASI bzw. ASII gebildet werden. Nach der Triggerung der nochmals unterteilten Sektorsignale werden diese zueinander phasenverschobenen Rechtecksignale in digitalen Speichern L1 und L2 gespeichert. Im Digitalspeicher L1 werden die Binärwerte der Abtaststelle ASI und im Digitalspeicher L2 die Binärwerte der Abtaststelle ASII gespeichert.

Die Speicher-Steuerschaltung A4 sorgt dafür, daß die analogen Abtastsignale U3, U4 der zweiten Abtaststelle ASII erst dann in der Analogsignal-Aufbereitungsschaltung A8 verarbeitet werden können, wenn die Abtastsignale U1, U2 der ersten Abtaststelle ASI vollständig unterteilt, digitalisiert und im zugehörigen Digitalspeicher L1 abgespeichert sind.

Nachdem der Unterteilungsvorgang auch für die Signale der letzten Abtaststelle - hier die Signale U3, U4 der Abtaststelle ASII - mit der Abspeicherung der Binärwerte im Digitalspeicher L2 abgeschlossen ist, werden die Binärwerte aller Abtaststellen ASI und ASII in einer Additionsstufe, die durch einen Volladdierer V gebildet wird, addiert und durch die Anzahl der Abtaststellen, hier also zwei, dividiert.

**Patentansprüche**

1. Positionsmeßeinrichtung (M) zur Ermittlung eines Winkels oder Weges (X), die zur Erhöhung der Auflösung eine Unterteilungsschaltung (EXEi) aufweist, welche zur Erzeugung von der gewünschten Auflösung entsprechenden zusätzlichen phasenverschobenen, analogen Hilfssignalen aus analogen periodischen Abtastsignalen (U1, U2) dient, die durch Abtastung einer inkrementalen Maßverkörperung (1) mittels einer Abtasteinrichtung (2) gewonnen werden, bei der die Unterteilungsschaltung (EXEi) wenigstens einen Komparator (Ti) in Form von wenigstens einem Trigger (T) zum Umformen der analogen Signale in Binärsignale aufweist, wobei die analogen periodischen Abtastsignale (U1, U2) einer Analogsignal-Aufbereitungsschaltung (Ai) zugeführt werden, in der die zusätzlichen phasenverschobenen, analogen Hilfssignale erzeugt werden, dadurch gekennzeichnet, daß in der Analogsignal-Aufbereitungsschaltung (Ai) eine Signalperiode (P) $\overline{\text{der Abtastsignale (U1, U2)}}$ in eine vorbestimmbare Anzahl von Sektoren (P1 bis Pn) zerlegt wird, und daß ein Schaltbaustein (3i) vorgesehen ist, der jeweils eine von Sektoren gebildete Gruppe von phasenverschobenen Analogsignalen aus der Analogsignal-Aufbereitungsschaltung (Ai) mit dem wenigstens einen Komparator (Ti) verbindet, und daß eine Steuerschaltung (4i), die eine Auswertelogik (41i) und einen an den Schaltbaustein (3i) angeschlossenen Wandlerbaustein (43i) aufweist, den Komparator (Ti) sukzessive den einzelnen Sektoren (P1 bis Pn) zuordnet, der diese nochmals unterteilt.

2. Positionsmeßeinrichtung nach Anspruch 1, dadurch gekennzeichnet, daß als Komparator (T2) zwei Trigger (T12, T22) und als Schaltbaustein (32) zwei Analogmultiplexer (312 und 322) vorgesehen sind, und daß die Trigger (T12, T22) mit Hilfe der Analogmultiplexer (312, 322) in Abhängigkeit von Steuersignalen einer Steuerschaltung (42) sukzessive den einzelnen Sektoren (Pi) zugeordnet werden.

3. Positionsmeßeinrichtung nach Anspruch 1, dadurch gekennzeichnet, daß als Komparator (T3, T4, T5) zwei Triggergruppen (T13, T23, T14, T24, T15, T25) und als Schaltbaustein ein Analogschalter (33, 34, 35) vorgesehen sind, und daß die Triggergruppen (T13, T23, T14, T24, T15, T25) mit Hilfe des Analogschalters (33, 34, 35) in Abhängigkeit von Steuersignalen einer Steuerschaltung (43, 44, 45) abwechselnd vorausschauend auf den nächsten aktuellen Sektor (Pi + 1) geschaltet werden.

4. Positionsmeßeinrichtung nach Anspruch 2, dadurch gekennzeichnet, daß die Steuerschaltung (42) eine Auswertelogik (412), einen getakteten Vor-Rückwärtszähler (422) und einen Wandlerbaustein (432) aufweist, der an die Analogmultiplexer (312, 322) angeschlossen ist und sie in Abhängigkeit vom Stand des Vor-Rückwärtszählers (422) umschaltet.

5. Positionsmeßeinrichtung nach Anspruch 3, dadurch gekennzeichnet, daß die Steuerschaltung (43) eine Auswertelogik (413), einen getakteten Vor-Rückwärtszähler (423) und einen Wandlerbaustein (433) aufweist, der an den Analogschalter (33) angeschlossen ist und ihn in Abhängigkeit vom Stand der Vor-Rückwärtszählers (423) umschaltet.

6. Positionsmeßeinrichtung nach Anspruch 5, dadurch gekennzeichnet, daß der Stand des Vor-Rückwärtszählers (423) von Eingangsinformationen an der Auswertelogik (413) abhängig ist, die aus dem Stand des Vor-Rückwärtszählers (423) und den Zuständen der Triggergruppen (T13, T23) gebildet werden.

7. Positionsmeßeinrichtung nach Anspruch 3, dadurch gekennzeichnet, daß die Steuerschaltung (44, 45) eine Auswertelogik (414, 415), eine dritte Triggergruppe (T34, T35) und einen Wandlerbaustein (434, 435) aufweist, der an den Analogschalter (34, 35) angeschlossen ist, und ihn in Abhängigkeit von Ausgangssignalen der dritten Triggergruppe (T34, T35) umschaltet, der die Abtastsignale (U1, U2) zugeführt werden.

8. Positionsmeßeinrichtung nach Anspruch 1, dadurch gekennzeichnet, daß die aus den Abtastsignalen

6

EP 0 320 596 B1

(U1, U2) gewonnenen Siganle der Sektoren (P1 bis Pn) in der Analogsignal-Aufbereitungsschaltung (A) invertiert werden.

9. Positionsmeßeinrichtung nach Anspruch 1, wobei zur Abtastung der Maßverkörperung (1) wenigstens zwei Abtaststellen (ASI, ASII) vorgesehen sind, dadurch gekennzeichnet, daß die analogen Abtastsignale (U1 bis Un) in Speichern (SH1 bis SH4) zwischengespeichert werden und daß mit Hilfe einer Speicher-Steuerschaltung (A4) die Abtastsignale (U1 bis Un) abtaststellenweise nacheinander der Analogsignal-Aufbereitungsschaltung (A8) zugeführt und anschließend unterteilt werden.

10. Positionsmeßeinrichtung nach Anspruch 9, dadurch gekennzeichnet, daß die unterteilten Signale jeder Abtaststelle (ASI, ASII) nacheinander digigalisiert und in einem Datenspeicher (L1, L2) gespeichert werden.

11. Positionsmeßeinrichtung nach Anspruch 10, dadurch gekennzeichnet, daß die digitalisierten Werte alle Abtaststellen (ASI, ASII) gemittelt werden.

12. Positionsmeßeinrichtung nach Anspruch 11, dadurch gekennzeichnet, daß zur Mittelung der digitalisierten Werte eine Additionsstufe (V) vorgesehen ist, in der die digitalisierten Werte aller Abtaststellen (ASI, ASII) zuerst addiert und anschließend durch die Anzahl der Abtaststellen dividiert werden.

**Claims**

1. Position measuring system (M) for determining an angle or displacement (X) which has a subdividing circuit (EXEi) for increasing resolution and serving to generate additional out-of-phase analog auxiliary signals corresponding to the desired resolution from analog periodical scanning signals (U1, U2) obtained by scanning an incremental measurement embodiment (1) by means of a scanning device (2), and in which the subdividing circuit (EXEi) has at least one comparator (Ti) in the form of at least one trigger (T) for converting the analog signals into binary signals, the analog periodical scanning signals (U1, U2) being fed to an analog signal processing unit (Ai) in which the additional out-of-phase analog auxiliary signals are generated, characterised in that a signal period (P) of the scanning signals (U1, U2) is split up in the analog signal processing circuit (Ai) into a predetermined number of sectors (P1 to Pn) and a switching module (31) is provided which at any given time connects a group, formed by sectors, of out-of-phase analog signals from the analog signal processing circuit (Ai) to the one comparator at least (Ti), and a control circuit (4i) having an evaluating logic (41i) and a converter module (43i) which is connected to the switching module (3i) assigns the comparator (Ti) successively to the individual sectors (P1 to Pn) and the comparator subdivides these once more.

2. Position measuring system according to claim 1, characterised in that two triggers (T12, T22) are provided as the comparator (T2) and two analog multiplexers (312 and 322) are provided as the switching module (32), and the triggers (T12, T22) are assigned successively to the individual sectors (Pi) with the aid of the analog multiplexers (312, 322) in dependence upon control signals of a control circuit (42).

3. Position measuring system according to claim 1, characterised in that two trigger groups (T13, T23, T14, T24, T15, T25) are provided as the comparator (T3, T4, T5) and an analog switch (33, 34, 35) is provided as the switching module, and the trigger groups (T13, T23, T14, T24, T15, T25) are switched alternately, looking ahead, to the next effective sector (Pi + 1) with the aid of the analog switch (33, 34, 35) in dependence upon control signals of a control circuit (43, 44, 45).

4. Position measuring system according to claim 2, characterised in that the control circuit (42) has an evaluating logic (412), a timed forward-backward counter (422) and a converter module (432) which is connected to the analog multiplexers (312, 322) and changes them over in dependence upon the state of the forward-backward counter (422).

5. Position measuring system according to claim 3, characterised in that the control circuit (43) has an evaluating logic (413), a timed forward-backward counter (423) and a converter module (433) which is connected to the analog switch (33) and changes it over in dependence upon the state of the forward-backward counter (423).

7

**6.** Position measuring system according to claim 5, characterised in that the state of the forward-backward counter (423) is dependent on input information to the evaluating logic (413) which is formed from the state of the forward-backward counter (423) and the states of the trigger groups (T13, T23).

**7.** Position measuring system according to claim 3, characterised in that the control circuit (44, 45) has an evaluating logic (414, 415), a third trigger group (T34, T35) and a converter module (434, 435) which is connected to the analog switch (34, 35) and changes it over in dependence upon output signals of the third trigger group (T34, T35) to which the scanning signals (U1, U2) are fed.

**8.** Position measuring system according to claim 1, characterised in that the signals of the sectors (P1 to Pn) which are produced from the scanning signals (U1,U2) are inverted in the analog signal processing circuit (A).

**9.** Position measuring system according to claim 1, wherein at least two scanning points (ASI, ASII) are provided for scanning the measurement embodiment (1), characterised in that the analog scanning signals (U1 to Un) are temporarily stored in memories (SH1 to SH4) and, with the aid of a memory control circuit (A4), the scanning signals (U1 to Un) are fed in succession from the scanning points to the analog signal processing circuit (A8) and then subdivided.

**10.** Position measuring system according to claim 9, characterised in that the subdivided signals of each scanning point (ASI, ASII) are digitized in succession and stored in a data store (L1, L2).

**11.** Position measuring system according to claim 10, characterised in that the digitized values of all the scanning points (ASI, ASII) are averaged.

**12.** Position measuring system according to claim 11, characterised in that, for averaging the digitized values, an addition stage (V) is provided in which the digitized values of all the scanning points (ASI, ASII) are first added together and then divided by the number of scanning points.

**Revendications**

**1.** Dispositif de mesure de position (M) pour la détermination d'un angle ou d'une course (X) qui présente, afin d'augmenter la résolution, un circuit-subdiviseur (EXEi) qui permet de produire des signaux auxiliaires analogiques déphasés supplémentaires correspondant à la résolution souhaitée à partir des signaux de lecture périodiques analogiques (U1, U2) obtenus par la lecture d'une mesure matérialisée (1) incrémentale à l'aide d'un dispositif de lecture (2), dans lequel le circuit-subdiviseur (EXEi) comporte au moins un comparateur (Ti) qui se présente sous la forme d'au moins un déclencheur (T) pour transformer les signaux analogiques en signaux binaires, les signaux de lecture périodiques (U1, U2) étant amenés à un circuit de préparation de signal analogique (Ai) dans lequel sont produits les signaux auxiliaires analogiques déphasés supplémentaires, **caractérisé** en ce qu'on décompose dans le circuit de préparation de signal analogique (Ai) une période de signal (P) des signaux de lecture (U1, U2) en un nombre prédéterminé de secteurs (P1 à Pn), en ce qu'il est prévu un élément de commutation (3i) qui relie chaque fois un groupe de signaux analogiques déphasés formés de secteurs provenant du circuit de préparation de signal analogique (Ai) à au moins un comparateur (Ti), et en ce qu'un circuit de commande (4i) qui comporte une logique d'exploitation (41i) et un élément transducteur (43i) relié à l'élément de commutation (3i) associe le comparateur (Ti) successivement aux différents secteurs (P1 à Pn) lequel comparateur divise de nouveau les secteurs.

**2.** Dispositif de mesure de position selon la revendication 1, **caractérisé** en ce qu'il est prévu comme comparateur (T2) deux déclencheurs (T12, T22) et comme élément de commutation (32) deux multiplexeurs analogiques (312 et 322), et en ce que les déclencheurs (T12, T22) sont affectés successivement aux différents secteurs (Pi) à l'aide des multiplexeurs analogiques (312, 322) en fonction de signaux de commande délivrés par un circuit de commande (42).

**3.** Dispositif de mesure de position selon la revendication 1, **caractérisé** en ce qu'il est prévu comme comparateur (T3, T4, T5) deux groupes de déclencheurs (T13, T23, T14, T24, T15, T25) et comme élément de commutation un commutateur analogique (33, 34, 35), et en ce qu'on commute les groupes de déclencheurs (T13, T23, T14, T24, T15, T25) alternativement d'avance sur le prochain secteur concerné (Pi + 1) à l'aide du commutateur analogique (33, 34, 35) en fonction de signaux de commande délivrés par un circuit de commande (43, 44, 45).

4. Dispositif de mesure de position selon la revendication 2, **caractérisé** en ce que le circuit de commande (42) comporte une logique d'exploitation (412), un compteur-positif-négatif (422) rythmé et un élément transducteur (432) qui est relié aux multiplexeurs analogiques (312, 322) et commute ceux-ci en fonction de l'état du compteur-positif-négatif (422).

5. Dispositif de mesure de position selon la revendication 3, **caractérisé** en ce que le circuit de commande (43) comporte une logique d'exploitation (413), un compteur-positif-négatif (423) rythmé et un élément transducteur (433) qui est relié au commutateur analogique (33) et commute celui-ci en fonction de l'état du compteur-positif-négatif (423).

6. Dispositif de mesure de position selon la revendication 5, **caractérisé** en ce que l'état du compteur-positif-négatif (423) dépend d'informations d'entrée dans la logique d'exploitation (413) qui sont formées à partir de l'état du compteur-positif-négatif (423) et des états des groupes de déclencheurs (T13, T23).

7. Dispositif de mesure de position selon la revendication 3, **caractérisé** en ce que le circuit de commande (44, 45) comporte une logique d'exploitation (414, 415), un troisième groupe de déclencheurs (T34, T35) et un élément transducteur (434, 435) qui est relié au commutateur analogique (34, 35) et qui commute celui-ci enú fonction de signaux de sortie du troisième groupe de déclencheurs (T34, T35) auquel sont amenés les signaux de lecture (U1, U2).

8. Dispositif de mesure de position selon la revendication 1, **caractérisé** en ce que les signaux des secteurs (P1 à Pn) obtenus à partir des signaux de lecture (U1, U2) sont inversés dans le circuit de préparation de signal analogique (A).

9. Dispositif de mesure de position selon la revendication 1, au moins deux points de lecture (ASI, ASII) étant prévus pour la lecture de la mesure matérialisée (1), **caractérisé** en ce que les signaux de lecture analogiques (U1 à Un) sont mémorisés dans des mémoires (SH1 à SH4) et en ce que les signaux de lecture (U1 à Un) sont amenés successivement conformément au point de lecture au circuit de préparation de signal analogique (A8) par l'intermédiaire d'un circuit de commande de mémoire (A4), à la suite de quoi ils sont subdivisés.

10. Dispositif de mesure de position selon la revendication 9, **caractérisé** en ce que les signaux subdivisés de chaque point de lecture (ASI, ASII) sont numérisés successivement et sont mémorisés dans une mémoire de données (L1, L2).

11. Dispositif de mesure de position selon la revendication 10, **caractérisé** en ce qu'on calcule la moyenne des grandeurs numérisées de tous les points de lecture (ASI, ASII).

12. Dispositif de mesure de position selon la revendication 11, **caractérisé** en ce qu'il est prévu, pour le calcul de la moyenne des valeurs numérisées, un étage additionneur (V) dans lequel les valeurs numérisées de tous les points de lecture (ASI, ASII) sont ajoutées puis divisées par le nombre de points de lecture.

## Fig. 1

Fig. 2

EP 0 320 596 B1

# Fig. 3

EXE3

A3

U1 0°~
U2 90°~

0°~
45°~
90°~
135°~
180°~

33

T13

T23

T3

413

433

43

423

0° S1
90° S2

EP 0 320 596 B1

Fig. 4

Fig. 5

14

Fig. 6

P

P1 P2 P3 P4 P5 P6 P7 P8

$0° = U1$

Umschaltung Tr.-Gruppe T1

1'
2'
3'  Trigger-gruppe
4'  T1
5'

6'
7'  Trigger-gruppe
8'  T2
9'
10'

Umschaltung Tr.-Gruppe T2

0°
90°

t

EP 0 320 596 B1

Fig. 7

EP 0 320 596 B1

Fig.8